# EUROPÄISCHE PATENTANMELDUNG

(11) **EP 4 271 146 A1**
(43) Veröffentlichungstag der Anmeldung: **01.11.2023**
(21) Anmeldenummer: 22170422.4
(22) Anmeldetag: 28.04.2022
(51) Int. Cl.: H05K 3/12, B41F 33/00, B41F 15/44, B41F 15/08

(54) **MASKENDRUCKVERFAHREN MIT OPTIMIERTEN PARAMETERN UND VORRICHTUNG**

(71) Anmelder: Siemens Aktiengesellschaft, 80333 München (DE)
(72) Erfinder: Blank, Rene, 12249 Berlin (DE); Erdmann, Michael, 14822 Borkheide (DE); Frühauf, Peter, 14612 Falkensee (DE); Heimann, Matthias, 14469 Potsdam (DE); Nerreter, Stefan, 15754 Heidesee OT Blossin (DE); Wormuth, Dirk, 12203 Berlin (DE)
(74) Vertreter: Siemens Patent Attorneys

(57) **Zusammenfassung**

Zur Bestimmung von optimierten Parameterwerten eines Maskendruckverfahrens wird nach dem Druckvorgang in einem Testverfahren ein Qualitätswert für das Substrat bestimmt, und es wird ein Bild von der Oberseite der Schablone erzeugt. Eine Relation zwischen dem Parameter, dem Qualitätswert und dem Schablonenbild wird ermittelt, und mithilfe der Relation wird ein optimierter Wert für den Parameter bestimmt. Beim Druckvorgang wird der optimierte Wert eingestellt und unter Verwendung des jeweiligen Schablonenbilds das Druckverfahren überwacht, wobei auf das Testverfahren verzichtet werden kann.

## Beschreibung

Die Erfindung betrifft ein Verfahren zum Bedrucken eines Substrats mit einem Medium unter Verwendung einer Druckmaske sowie eine entsprechende Vorrichtung.

Maskendruckverfahren bezeichnet ein Druckverfahren, bei dem das zu bedruckende Material (Substrat) mit einer Schablone Druckmaske bedeckt wird und das zu druckende Medium mittels eines Rakels durch Öffnungen der Druckmaske auf das Substrat aufgebracht wird. Als Druckmaske kann beispielsweise ein Sieb oder eine Kunststoff- oder Metallschablone eingesetzt werden; im Folgenden wird der Begriff "Schablone" für alle Arten von Druckmasken verwendet. Unterschiedliche Anwendungsgebiete sind bekannt, beispielsweise kann das Substrat mit Farbe, Lack oder einem anderen pastösen Medium bedruckt werden. Es wird auch bei der Fertigung von Elektronikbaugruppen eingesetzt, insbesondere wird dabei ein Leiterplattensubstrat mit einem Lotmaterial bedruckt, um Verbindungen des Leiterplattensubstrats in sich oder mit Elektronikkomponenten herstellen zu können.

Dabei ist wichtig, dass das pastöse Medium, also beispielsweise das Lotmaterial, nach dem Rakeln einerseits die Öffnungen (Aperturen) der Schablone weitgehend vollständig füllt, andererseits nicht über die substratabgewandte Seite der Schablone (Schablonenoberseite) hinaussteht. Andernfalls ist der Druckvorgang und dadurch auch die herzustellende Leiterplatte fehlerhaft: Im ersten Fall werden gewünschte elektrische Verbindungen nicht hergestellt, im zweiten Fall ergibt sich eine höhere Schichtdicke als vorgegeben und das Druckbild wird unsauber, ferner können Lotreste auf der Schablonenoberseite bleiben. Da Lotreste für den nächsten Druckvorgang störend sind, müssen ggf. Reinigungsschritte durchgeführt werden.

Der Druckprozess wird durch verschiedene Parameter beeinflusst, beispielsweise Druck und Geschwindigkeit, mit der das Rakel über die Schablone verfahren wird, oder die Geschwindigkeit, mit der die Schablone vom Substrat abgehoben wird. Neben derartigen steuerbaren Parametern, die im Prinzip für jedes einzelne Substrat neu einstellbar sind, beeinflussen auch weitere Parameter das Ergebnis, insbesondere solche, die üblicherweise nur einmal je Produktionstag bzw. Lauf eingestellt werden (beispielsweise Ausrichtung des Rakels zur Schablone), ferner solche, die in einer Art Setup einmalig für einen Baugruppentyp eingestellt werden (beispielsweise Rakelmaterial, -dicke, -länge, Lotpastenprodukt), sowie solche, die Designdaten darstellen (beispielsweise Dicke der Schablone, Anordnung und Form der Schablonenöffnungen). Ferner fallen unter den Begriff Parameter auch nicht oder nur indirekt beeinflussbare Randbedingungen des Druckprozesses (beispielsweise Temperatur, Feuchte, Vibrationen, Luftdruck.

Durch die Wahl passender Parameterwerte können Fehler minimiert werden. Beispielsweise können eine zu hohe Schichtdicke des Lotmaterials und verbleibende Reste auf der Schablonenoberseite durch geeignete Werte für den Rakeldruck und eine ausreichend parallele Ausrichtung von Rakel und Schablonenoberfläche weitgehend vermieden werden.

Zur Prüfung des Druckergebnisses wird im Stand der Technik ein sogenannter Solder-Paste-Inspection-Schritt (SPI) durchgeführt. Das bedruckte Substrat wird aus der Druckerkammer herausgeführt und optisch untersucht. Dazu wird mindestens ein Bild des bedruckten Substrats analysiert, beispielsweise durch direkten Vergleich mit einem Sollbild, oder es werden bestimmte Parameterwerte ermittelt und die Abweichungen von vorgegebenen Sollwerten ermittelt. Für eine Vielzahl von Lot-Pads werden bestimmte Kenngrößen wie beispielsweise der Ort in x- und y-Richtung und die Höhe ermittelt und die prozentuale Abweichung von den Sollwerten bestimmt. Bei Über- oder Unterschreiten einer vorgegebenen Toleranzschwelle (d.h. einem zu großen Fehler im Druckprozess) wird die Leiterplatte verworfen. Alternativ oder zusätzlich wird eine optische Inspektion nach weiteren Fertigungsschritten durchgeführt (sog. Automated optical inspection, AOI).

Es kann auch die Schablonenunterseite (d.h. die dem Substrat zugewandte Seite der Schablone) nach dem Abheben vom Substrat optisch untersucht werden, um zu erkennen, ob in Aperturen Lotreste verblieben sind, so dass an den korrespondierenden Stellen des Substrats kein Lotpad aufgebracht wurde.
Diese bekannten Verfahren sind aufwendig und benötigen komplexere Druckerkammern oder zusätzliche Prozessstationen in der Fertigungslinie. Ferner kann mit ihnen zwar ein aufgetretener Fehler festgestellt werden, aber sie liefern keine Aussage, wie der Druckprozess geändert werden muss, um den Fehler zukünftig zu vermeiden. Für letzteres ist die Begutachtung durch Experten notwendig, die aufgrund ihrer Erfahrung erkennen, welche Parameter des Druckvorgangs in welcher Weise geändert werden müssen oder können, um den Fehler möglicherweise abzustellen.

Aufgabe der Erfindung ist es, in einem Maskendruckverfahren aufgetretene Fehler auf einfache Weise zu erkennen und eine Möglichkeit zu schaffen, diese Fehler zu vermeiden.

Diese Aufgaben werden gelöst durch ein Verfahren mit den Merkmalen des Patentanspruchs 1, durch ein Verfahren mit den Merkmalen des Patentanspruchs 5 und durch eine Anordnung gemäß Patentanspruch 8. Vorteilhafte Ausgestaltungen der Erfindung sind in den Unteransprüchen angegeben.

Die Erfindung sieht vor, einen optimierten Wert für mindestens einen Parameter eines Druckverfahrens mithilfe eines machine-learning-Verfahrens zu ermitteln. Dafür wird ein Druckvorgang mit einem zugeordneten Wert für den Parameter durchgeführt, und es wird ein Bild von der Oberseite der Schablone vor und/oder nach Abheben der Schablone von der Substratoberfläche aufgenommen. Für das Druckergebnis, d.h. für das bedruckte Substrat, wird ein Qualitätswert ermittelt.

Der Druckvorgang wird mit einem geänderten Wert des Parameters erneut durchgeführt, ein Bild der Schablonenoberseite vor und/oder nach Abheben der Schablone aufgenommen und erneut der zugehörige Qualitätswert des Druckergebnisses ermittelt. Eine Relation, d.h. ein Zusammenhang zwischen Parameter, Schablonenbild und Qualitätswert wird in einem machine-learning-Verfahren ermittelt. Mit dem machine-learning-Verfahren wird danach ein optimierter Wert des Parameters bestimmt, d.h. ein Parameterwert, der zu einem verbesserten Qualitätswert für das Druckergebnis führt.

Gemäß eines Ausführungsbeispiels wird der Druckvorgang mehrfach mit jeweils geänderten Werten des Parameters und/oder mit jeweils geänderten Werten weiterer Parameter durchgeführt, jeweils ein Bild der Schablonenoberseite erstellt und dem jeweiligen Druckergebnis ein Qualitätswert zugeordnet. Dadurch wird das machine-learning-Verfahren bzw. der ermittelte Zusammenhang zwischen Parametern und Qualitätswert zuverlässiger. Aufgrund der ermittelten Relation zwischen Parametern und Qualitätswert durch eine Recheneinheit kann bestimmt werden, welche Korrekturmaßnahmen bei einem schlechten Druckergebnis durchzuführen sind, d.h. welche Parameter in welcher Weise geändert werden sollen, um Qualitätswert zu erhöhen.

Zur Ermittlung des Qualitätswerts wird vorzugsweise eine optische Kontrolle des bedruckten Substrats durchgeführt. Dabei kann beispielsweise ein Bild des bedruckten Substrats mit einem Sollbild verglichen, alternativ oder zusätzlich können die insbesondere prozentualen Abweichungen bei einer oder mehreren vorgegebenen Kenngrößen (Parameterwerten) bewertet. Je geringer diese Abweichungen sind, desto höher ist der Qualitätswert. Bei mehreren Kenngrößen können die Abweichungen ggf. unterschiedlich gewichtet und in geeigneter Weise miteinander kombiniert werden.

Das Verfahren kann vorteilhaft in der Elektronikfertigung eingesetzt werden, wobei als Substrat ein Leiterplattensubstrat und als Medium ein elektrisch leitendes Lotmaterial verwendet wird. Die Ermittlung des Qualitätswerts kann dann mithilfe eines SPI-Schritts durchgeführt werden. Das bedruckte Substrat wird in einer üblichen SPI-Station mit einem bekannten Verfahren optisch ausgewertet, indem die insbesondere prozentuale Abweichung bei einer oder mehreren Kenngrößen von entsprechenden Sollwerten bestimmt wird.

Als Parameter können beispielsweise folgende steuerbaren Parameter verwendet werden: Rakelgeschwindigkeit, Rakeldruck, Reinigungszyklus, Verfahrweg, Lift-off Geschwindigkeit (Abheben der Schablone nach dem Druckvorgang), Absprung (d.h. ein evtl. vorhandener Abstand zwischen der Schablone und dem Substrat).

Alternativ oder zusätzlich können als Parameter beispielsweise folgende Parameter verwendet werden, die mehr oder weniger steuerbar bzw. wählbar sind und/oder Randbedingungen des Prozesses darstellen: relative Ausrichtung von Rakel und Schablonenoberfläche, Rakelmaterial, Rakeldicke und -länge, Chargennummer, Art und Hersteller des Mediums (Paste), Feinheit der Metallpartikel, Geometrie der Aperturen, Dicke der Schablone, Lufttemperatur, Luftfeuchte, Vibrationen, Luftdruck.

Das Schablonenbild kann aufgenommen werden, wenn die Schablone noch auf dem Substrat aufliegt. An einem solchen Bild ist insbesondere erkennbar, ob alle Aperturen mit Lotmaterial gefüllt sind oder einzelne leer oder nur teilweise gefüllt sind.

Alternativ oder zusätzlich kann das Schablonenbild aufgenommen werden, nachdem die Schablone vom Substrat abgehoben wurde. An einem solchen Bild ist insbesondere erkennbar, ob nach dem Abheben Lotmaterial in Aperturen verblieben ist und damit nicht oder nur unzureichend auf das Substrat gedruckt wurde.

In beiden Fällen ist erkennbar, ob Lotmaterial auf der Schablonenoberfläche an Stellen ohne Öffnungen verblieben ist.

Das machine-learning-Verfahren ermöglicht, komplexe Zusammenhänge zwischen Parametern und Qualitätswert zu ermitteln, die Parameter zu identifizieren, die das Ergebnis maßgeblich beeinflussen und Parameterwerte für ein optimales Ergebnis zu bestimmen (als Lernphase bezeichnet). Als machine-learning-Verfahren kann ein bekanntes Optimierungsverfahren eingesetzt werden, beispielsweise eine Bayesianische Optimierung. Durch Hinzunahme weiterer Parameter kann mithilfe des machine-learning-Verfahrens ein verbessertes Modell mit höherer Zuverlässigkeit erzeugt werden.

Die Erfindung umfasst auch ein Verfahren zur Herstellung eines mit einem Medium bedruckten Substrats, bei dem für mindestens einen Parameter für den Druckprozess ein optimaler Wert ermittelt wird, und bei dem die Relation zwischen Parameter und Qualitätswert wie vorstehend beschrieben ermittelt wird. In dieses Herstellungsverfahren, also die eigentliche Produktion der bedruckten Leiterplatten oder allgemein des bedruckten Substrats, kann die Lernphase integriert werden, mit anderen Worten, die in der Lernphase hergestellten bedruckten Substrate können bereits die herzustellenden Produkte darstellen. Die benötigte Änderung von einem oder mehreren Parameterwerten wird durch die in der Praxis auftretenden Schwankungen bei den eingestellten Parameterwerten erzielt, d.h. der geänderte Wert ergibt sich bei Durchführung des Verfahrens und wird nicht dezidiert eingestellt.

In einem bevorzugten Ausführungsbeispiel erfolgt die Herstellung nach der Lernphase, in der wie beschrieben ein optimierter Wert für mindestens einen Parameter ermittelt wurde. In dieser Produktionsphase wird wie in der Lernphase ein Bild der Schablonenoberseite vor und/oder nach Abheben vom Substrat erzeugt. Anhand des Schablonenbilds wird das Druckverfahren überwacht und/oder das bedruckte Substrat bewertet. Dadurch können vorteilhaft in der Lernphase größere und/oder gezielte Änderungen bei den Parameterwerten vorgenommen werden, wodurch das machine-learning-Verfahren ein schnelleres und/oder zuverlässigeres Ergebnis liefert.

Wenn die Produktionsphase der Lernphase nachgeschaltet ist, wird in der Produktionsphase vorzugsweise nicht das Druckergebnis, also das bedruckte Substrat, optisch geprüft, sondern es wird wie in der Lernphase ein Bild der Oberseite der Schablone vor und/oder nach dem Abheben von der Substratoberfläche erstellt. Anhand des Schablonenbildes kann dem Druckvorgang bzw. dem bedruckten Substrat ein Qualitätswert zugeordnet werden, da dieser Zusammenhang in der Lernphase durch das machine-learning-Verfahren erlernt wurde. Dadurch ist es möglich, im laufenden Produktionsbetrieb auf den SPI-Schritt zu verzichten oder ihn zumindest nicht nach jedem Druckvorgang durchzuführen. Anhand des Schablonenbildes kann der Qualitätswert des bedruckten Substrats ermittelt werden, ohne dass ein SPI-Schritt und/oder ein AOI-Schritt beim bedruckten Substrat durchgeführt wird. Die Produktion kann dadurch beschleunigt werden und der apparative Aufbau vereinfacht werden.

Das Einstellen der Parameter kann automatisiert erfolgen, und es können bedruckte Substrate hergestellt werden, die einen vorgegebenen Qualitätswert aufweisen. Alternativ oder zusätzlich ist es möglich, durch eine Auswertung des Schablonenbilds mithilfe der ermittelten Relation zwischen Parameterwert, Qualitätswert und Schablonenbild den eingestellten Parameterwert zu korrigieren, also bei Auftreten von Fehlern und Absinken der Qualität so zu ändern, dass die Fehler bei nachfolgenden Druckvorgängen verringert oder vermieden werden.

Es liegt im Rahmen der Erfindung, in der Produktionsphase das Lernverfahren kontinuierlich oder nicht-kontinuierlich fortzusetzen, um das Modell weiter zu verbessern. Dabei wird in der Produktionsphase zusätzlich der Qualitätswert der hergestellten bedruckten Substrate ermittelt und für das machine-learning-Verfahren verwendet. Wie oben dargestellt, kann auch auf eine getrennte Lernphase verzichtet werden, wenn das machine-learning-Verfahren in der Produktionsphase durchgeführt wird.

Die Erfindung umfasst auch eine Vorrichtung zur Durchführung der Verfahren. Diese umfasst eine Aufnahmevorrichtung für das zu bedruckende Substrat, eine Halterung für die Schablone, eine Halterung für ein Rakel sowie eine Bildaufnahmevorrichtung, die so angeordnet ist, dass sie ein Bild der Oberseite der Schablone nach erfolgtem Druckvorgang aufnehmen kann. Die Bildaufnahmevorrichtung ist mit einer Recheneinheit verbindbar, so dass erstellte Bilder der Schablone an die Recheneinheit übermittelt werden können.

Die Bildaufnahmevorrichtung kann beispielsweise am Gehäuse oder an der Halterung für das Rakel angeordnet sein.

Vorzugsweise umfasst die Vorrichtung eine mit der Bildaufnahmevorrichtung verbundene Recheneinheit, die mit einer Testeinheit verbunden ist. Die Recheneinheit ist ausgelegt, für einen Druckvorgang einen oder mehrere Parameterwerte, mindestens ein Bild der Schablone nach dem Druckvorgang und einen von der Testeinheit ermittelten Qualitätswert zu speichern und eine Relation zwischen diesen Daten zu ermitteln. Dabei kann der Qualitätswert auch von der Recheneinheit ermittelt werden, wobei hierzu die Testeinheit Daten des Testergebnisses an die Recheneinheit liefert.

Bei der Testeinheit handelt es sich vorzugsweise um eine Einheit für einen SPI-Schritt, die als Testergebnis ein Bild des bedruckten Substrats und/oder Daten aus einem optischen Vergleich des bedruckten Substrats mit einem Sollbild liefert.

Die Erfindung wird im Folgenden anhand von Ausführungsbeispielen näher erläutert. Es zeigen in schematischer Darstellung
Fig 1 und 2: eine Vorrichtung zur Durchführung des erfindungsgemäßen Verfahrens während und am Ende des Druckvorgangs
Fig. 3 ein Bild der Schablone vor dem Druckvorgang
Fig. 4 ein Bild der auf dem Substrat liegenden Schablone am Ende des Druckvorgangs
Fig. 5 ein Bild der auf dem Substrat liegenden Schablone am Ende eines fehlerhaften Druckvorgangs
Fig. 6 ein Bild der vom Substrat abgehobenen Schablone am Ende eines fehlerhaften Druckvorgangs
Fig. 7 ein Ablaufdiagramm des Verfahrens

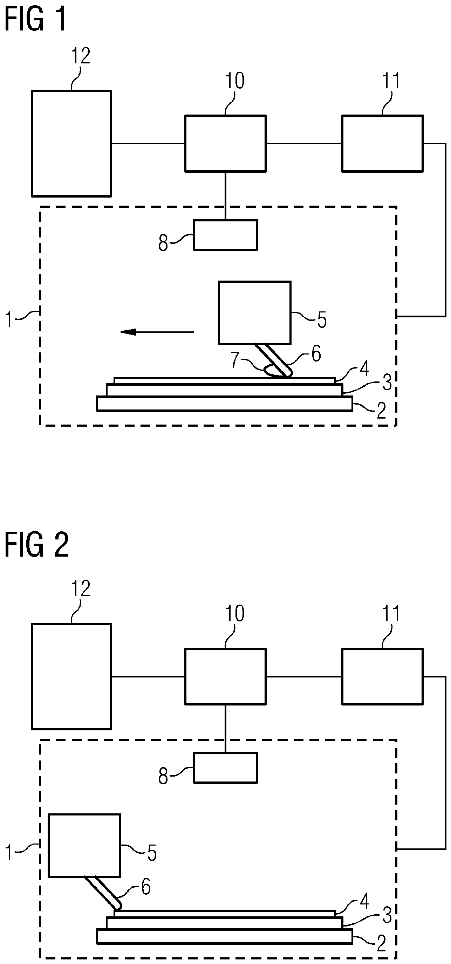

Fig.1 zeigt schematisch eine Kammer 1 eines Schablonendruckers mit einer Aufnahmevorrichtung 2 für ein Leiterplattensubstrat 3. Auf der Substratoberfläche ist eine Schablone 4 mittels einer nicht dargestellten Halterung angeordnet. Eine Rakeleinrichtung umfasst eine Halterung 5 für ein Rakel 6. Beim Druckvorgang wird Lot als Medium 7 mithilfe des Rakels 6 über die Oberfläche der Schablone 4 gestrichen, dies ist durch den Pfeil angedeutet. Dabei werden Öffnungen in der Schablone mit dem Lot gefüllt. In der Kammer ist ferner eine Bildaufnahmevorrichtung 8 so angeordnet, dass sie die Oberfläche der Schablone 4 aufnehmen kann.

Eine Recheneinheit 10 ist mit der Kamera 8 verbunden, so dass Bilder der Kamera an die Recheneinheit übermittelt werden können. Ferner ist die Recheneinheit 10 mit einer Steuereinheit 11 verbunden. Die Steuereinheit steuert zum einen den Druckvorgang, indem sie beispielsweise Parameterwerte einstellt und die Bewegung der Rakeleinheit steuert. Hierzu empfängt sie Daten von der Recheneinheit 10.

Zumindest in der Lernphase ist die Recheneinheit 10 mit einer Testeinheit 12 in Form einer SPI-Station verbunden.

Fig. 2 zeigt die Anordnung am Ende des Druckvorgangs, das Rakel hat das Ende der Schablone 4 erreicht. Mit der Kamera 8 wird nun ein Bild von der Schablonenoberrseite erstellt. Im Ausführungsbeispiel liegt bei der Aufnahme die Schablone 4 auf dem Substrat 3, alternativ oder zusätzlich ist es möglich, ein Bild nach Abheben der Schablone vom Substrat aufzunehmen. Die Bilder werden an die Recheneinheit 10 übermittelt. Die mit Lot bedruckte Leiterplatte 3 wird in die Testeinheit 12 verfahren und dort getestet; insbesondere wird ein Bild von der Substratoberfläche aufgenommen und daraus ermittelte Parameterwerte (u.a. Ort, Fläche und Volumen der Lotpads) mit Sollwerten verglichen. Die resultierenden Daten, beispielsweise prozentuale Abweichungen von Sollwerten, werden an die Recheneinheit 10 übermittelt, die daraus einen Qualitätswert bestimmt.

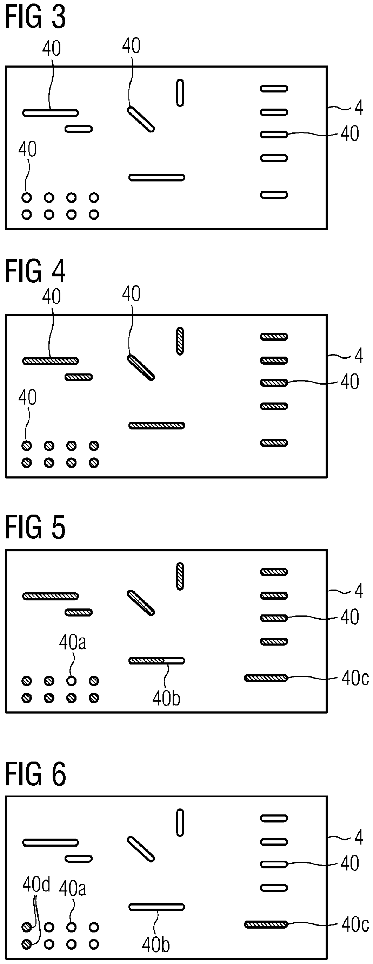

Fig. 3 zeigt die Oberfläche der Schablone 4. Sie weist Öffnungen 40 (Aperturen) auf, durch die im Druckvorgang das Medium auf die Substratoberfläche gebracht wird. Die Dicke der Schablone entspricht dabei der Dicke des gewünschten Auftrags.

Fig. 4 zeigt das Bild der Oberfläche der noch auf dem Substrat liegenden Schablone 4 nach dem Druckvorgang für den Fall eines fehlerfreien Drucks. Die Aperturen 40 sind vollständig gefüllt, das Rakel hat das Lot sauber von der Schablonenoberfläche abgezogen, so dass keine Lotreste außerhalb der Aperturen erkennbar sind.

Fig. 5 zeigt das Bild der Oberfläche der noch auf dem Substrat liegenden Schablone 4 nach dem Druckvorgang für den Fall eines fehlerhaften Drucks. Einige Aperturen sind nicht (40a) oder nicht vollständig (40b) gefüllt. Bei anderen Aperturen 40c sind Lotreste außerhalb der Aperturen auf der Schablonenoberfläche verblieben.

Fig. 6 zeigt das Bild der Oberfläche der vom Substrat abgehobenen Schablone 4 nach dem Druckvorgang für den Fall eines fehlerhaften Drucks entsprechend Fig. 3. Durch das Abheben sind weitere Fehler aufgetreten, da Lotmaterial in den Aperturen 40d und 40c hängen geblieben ist. Hier sind also die gewünschten Kontakte auf der Leiterplatte nicht hergestellt worden. An diesem Bild der Schablone ist anderseits nicht erkennbar, dass die Öffnung 40a beim Rakeln nicht gefüllt wurde und dadurch hier auch ein Fehler liegt. Es ist also vorteilhaft, ein Bild der Schablonenoberfläche vor und nach dem Abheben vom Substrat zu erstellen, um Fehler zuverlässig zu erfassen.

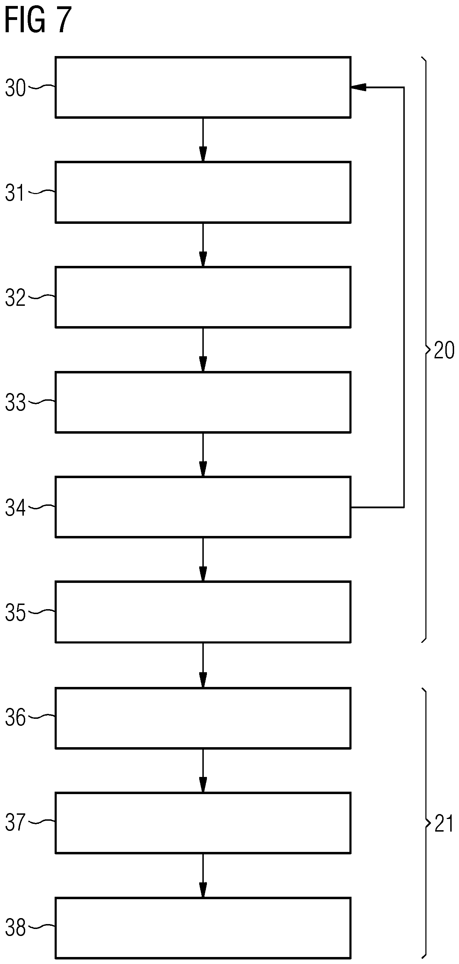

Fig. 7 zeigt schematisch ein Ausführungsbeispiel für den Ablauf des Verfahrens. In einer Lernphase 20 wird im Schritt 30 ein Druckvorgang mit vorgewählten Werten für die Parameter des Druckvorgangs ausgeführt. Es können beispielsweise ein Rakelmaterial, eine Rakelgeschwindigkeit, ein Rakeldruck und ein Schablonentyp ausgewählt werden. Die Steuereinheit 11 speichert die Parameterwerte und steuert den Druckvorgang entsprechend. Nach Beenden des Drucks steuert die Steuereinheit 11 die Aufnahme des Bildes der Schablonenoberfläche durch die Kamera 8 (Schritt 31), vorzugsweise wird jeweils ein Bild vor und nach Abheben der Schablone 4 vom Substrat 3 aufgenommen. Die Bilder und die zugehörigen Parameterwerte werden an die Recheneinheit 10 übermittelt.

In Schritt 32 wird das bedruckte Substrat in der Teststation 12 analysiert, insbesondere werden in einem SPI-Schritt mindestens ein Bild des bedruckten Substrats aufgenommen und die Geometrie der Druckdepots bzw. Lotpads gemessen. Es wird ein Qualitätswert für das Druckergebnis ermittelt, entweder in der Teststation 12 oder in der Recheneinheit 10 nach Übermittlung der Daten an die Recheneinheit. Beispielsweise können prozentuale Abweichungen von Sollwerten für Lage und Dicke der gedruckten Lot-Pads gewichtet und kombiniert werden, um den Qualitätswert zu berechnen. In Schritt 33 werden der Qualitätswert, die Schablonenbilder und die verwendeten Parameterwerte in der Recheneinheit gespeichert.

In Schritt 34 wird der Wert von zumindest einem Parameter geändert. Es wird ein Druckvorgang mit den geänderten Parameterwerten ausgeführt und die beschriebenen Schritte 30 - 34 werden in einer Schleife ausgeführt, bis eine ausreichende Anzahl von Daten vorhanden ist. Es wird in Schritt 35 ein machine-learning-Verfahren angewendet, um aus den Daten die Relation zwischen Parametern, Schablonenbild und Qualitätswert zu ermitteln. Damit ist die Lernphase 20 abgeschlossen.

Anschließend wird die Produktionsphase 21 für die Herstellung von bedruckten Substraten durchgeführt. In Schritt 36 ermittelt die Recheneinheit den optimalen Qualitätswert und die dazugehörigen Parameterwerte und Schablonenbilder. Die Steuereinheit führt den Druckvorgang mit diesen optimalen Parameterwerten durch (Schritt 37). Nach einem Druckvorgang wird in Schritt 38 mindestens ein Schablonenbild aufgenommen und geprüft, ob es mit dem erwarteten optimalen Schablonenbild übereinstimmt oder innerhalb eines vorgegebenen Toleranzbereichs liegt. Bei zu großen Abweichungen können geeignete Maßnahmen, die mittels machine learning in der Lernphase ermittelt wurden bzw. sich aus der ermittelten Relation ergeben, durchgeführt werden. Insbesondere kann aus der Relation abgeleitet werden, welche Parameter des Druckverfahrens in welcher Weise geändert, d.h. wie sein Wert korrigiert werden muss, um den gewünschten Qualitätswert zu erreichen. Auf einen SPI-Schritt kann verzichtet werden. Es kann aber auch weiterhin ein bedrucktes Substrat mittels SPI analysiert werden, und die erhaltenen Daten können für eine weitere Verbesserung verwendet werden. Die Schritte 37 und 38 werden in einer Schleife durchgeführt, um weitere Substrate zu bedrucken.

Die in den Ausführungsbeispielen beschriebenen Merkmale und Aspekte der Erfindung können selbstverständlich miteinander in unterschiedlicher Weise kombiniert werden. Insbesondere können die Merkmale nicht nur in den beschriebenen Kombinationen, sondern auch in anderen Kombinationen oder für sich genommen verwendet werden.

### Bezugszeichen:

- 1: Kammer
- 2: Aufnahmevorrichtung
- 3: Leiterplattensubstrat
- 4: Schablone
- 40 a-d: Aperturen
- 5: Rakeleinrichtung /Halterung
- 6: Rakel
- 7: Lot
- 8: Kamera
- 10: Recheneinheit
- 11: Steuereinheit
- 12: Testeinheit
- 20: Lernphase
- 21: Produktionsphase
- 30-35: Schritte der Lernphase
- 36-38: Schritte der Produktionsphase

## Patentansprüche

1. Verfahren zur Bestimmung von optimierten Parameterwerten eines Druckverfahrens, bei dem ein zu bedruckendes Substrat unter Verwendung einer Schablone mit einem Medium bedruckt wird,
mit folgenden Schritten:
- Durchführen eines Druckvorgangs mit einem zugeordneten Wert für mindestens einen Parameter
- Erstellen eines Bilds der Schablonenoberseite (4) vor und/oder nach Abheben der Schablone von der Substratoberfläche (3)
- Ermitteln eines Qualitätswerts für das in dem Druckvorgang bedruckte Substrat (3)
- Durchführen des Druckvorgangs mit einem geänderten Wert für den Parameter
- Erneutes Erstellen eines Bilds der Schablonenoberseite (4) vor und/oder nach Abheben der Schablone (4) von der Substratoberfläche
- Erneutes Ermitteln des zugehörigen Qualitätswerts für das in dem Druckvorgang bedruckte Substrat (3)
- Ermitteln einer Relation zwischen dem Parameter, dem Qualitätswert und dem Schablonenbild mithilfe eines machine-learning-Verfahrens
- Ermitteln eines optimierten Werts für den Parameter anhand der Relation.

2. Verfahren nach dem vorhergehenden Anspruch, **dadurch gekennzeichnet, dass** der Qualitätswert durch eine optische Kontrolle des bedruckten Substrats (3) ermittelt wird.

3. Verfahren nach einem der vorhergehenden Ansprüche, **dadurch gekennzeichnet, dass** als Substrat (3) ein Leiterplattensubstrat und als Medium (7) ein elektrisch leitendes Lotmaterial verwendet wird, und dass der Qualitätswert durch einen Solder-Paste-Inspection-Schritt ermittelt wird.

4. Verfahren nach einem der vorhergehenden Ansprüche, **dadurch gekennzeichnet, dass** als Parameter eine Rakelgeschwindigkeit, ein Rakeldruck, ein Reinigungszyklus, ein Verfahrweg, eine Lift-off Geschwindigkeit der Schablone, eine relative Ausrichtung von Rakel und Schablonenoberfläche, ein Rakelmaterial, eine Chargennummer oder eine Eigenschaft des Mediums, eine geometrische Angabe der Schablonenöffnungen und/oder eine Dicke der Schablone verwendet wird.

5. Maskendruckverfahren zur Herstellung eines mit einem Medium bedruckten Substrats,
- bei dem für mindestens einen Parameter eine Relation mit einem Qualitätswert und einem Schablonenbild gemäß einem der Ansprüche 1 - 4 ermittelt wird
- bei dem der optimierte Wert für den Parameter eingestellt wird,
- bei dem ein Bild der Oberseite Schablone (4) vor und/oder nach Abheben der Schablone von der Substratoberfläche erstellt wird.
- bei dem das Schablonenbild für die Überwachung des Druckverfahrens und/oder die Bewertung des bedruckten Substrats verwendet wird.

6. Maskendruckverfahren nach dem vorhergehenden Anspruch, bei dem für die Ermittlung der Relation des Parameters mit dem Qualitätswert der Parameter zunächst auf einen Wert eingestellt wird und der geänderte Wert für den Parameter sich aus Schwankungen des Parameters ergibt.

7. Maskendruckverfahren nach einem der vorhergehenden Ansprüche, bei dem der eingestellte Wert für den Parameter nach Auswertung des Schablonenbilds korrigiert wird.

8. Vorrichtung zum Bedrucken eines Substrats mit einem Medium unter Verwendung einer Schablone mit
- einer Aufnahmevorrichtung (2) für das Substrat (3),
- einer Halterung für die Schablone (4),
- einer Bildaufnahmevorrichtung (8), die so angeordnet ist, dass sie ein Bild von der Oberseite der Schablone (4) nach erfolgtem Druckvorgang aufnehmen kann.

9. Vorrichtung nach dem vorhergehenden Anspruch, **dadurch gekennzeichnet, dass** sie eine Recheneinheit (10) umfasst, die mit der Bildaufnahmeeinheit (8) und mit einer Testeinheit (12) verbunden ist, wobei die Recheneinheit ausgestaltet ist, in einem machine-learning-Verfahren eine Relation zwischen mindestens einem Parameter eines Druckvorgangs, einem dem bedruckten Substrat mithilfe der Testeinheit (12) zugeordneten Qualitätswert und dem nach dem Druckvorgang aufgenommenen Bild der Schablone (4) zu ermitteln.
